# EUROPEAN PATENT SPECIFICATION

(11) **EP 1 880 862 B1**
(45) Date of publication and mention of the grant of the patent: **05.01.2011**
(21) Application number: 07112629.6
(22) Date of filing: 17.07.2007
(51) Int. Cl.: B41N 1/24, B41M 1/12

(54) **Screen printing plate**
Siebdruckplatte
Plaque d'impression sérigraphique

(30) Priority: 18.07.2006 JP 2006195980
(43) Date of publication of application: 23.01.2008
(73) Proprietor: Ricoh Company, Ltd., Tokyo 143-8555 (JP)
(72) Inventor: Araumi, Mayuka Ricoh Company, Ltd, Tokyo 143-8555 (JP); Murakami, Akishige Ricoh Company, Ltd., Tokyo 143-8555 (JP)
(74) Representative: Barz, Peter

(56) References cited:
- DE-A1- 2 256 263
- JP-A- 2002 160 467
- US-A1- 2003 124 757

## Description

### BACKGROUND OF THE INVENTION

### 1. Field of the Invention

The present invention relates to a screen printing plate, a thick film having through-holes, a multilayer wiring structure, and an image display apparatus.

### 2. Description of the Related Art

Known semiconductor devices which have transistors and diodes on substrates or semiconductor wafers are of a multilayer wiring structure to enhance their degree of integration. In such a multilayer wiring structure, an interlayer insulation film which includes via-holes for electrical connection of wiring is used.

In recent years and continuing, an organic insulation film having a relative permittivity smaller than that of a silicone dioxide film is widely used as a material of the interlayer insulation film. Since photolithography is employed to form through-holes in the organic insulation film, however, using the organic insulation film requires a large number of steps as a manufacturing method and is disadvantageous in terms of cost.

In a screen printing method, on the other hand, a squeegee is slid to discharge ink so as to perform printing with the ink deposited on a mesh (screen printing plate) having an emulsion formed in a non-discharging area from which no ink is discharged. The method has advantages in that the number of steps can be reduced and the usage efficiency of a material is high. The screen printing method is thus capable of forming fine patterns with an easy technique. Therefore, it is being used for the wiring step of transistors or the like, as well. However, it is not suitable for forming minute through-holes. First, this is because it adopts a dynamic process, resulting in the ink oozing out under the non-discharging area of the screen printing plate at printing being caused to be printed on the substrate. Second, this is because the surface of fluid ink immediately after the printing becomes even due to gravity, and at the same time, a small amount of feathering is caused to occur (leveling). In forming minute through-holes, therefore, there is a high probability of the ink oozing out under the non-discharging area at printing and the ink leveling off on all sides after printing filling in the through-holes. Consequently, it is said that the limit under the conventional technique is a 100 µm square through-hole. In addition, since the screen printing method is dependent on plural parameters such as clearance (distance between the screen plate and the substrate), the angle, pressure, and speed of the squeegee, it is difficult.to form minute through-holes in a stable manner; a through-hole in a large area printing is on the order of 300 µm square using time-proven methods.

This particular screen printing method is frequently used for filling in via-holes. In patent document 1, however, it is used for printing paste films made of a conductive paste with patterns forming island-shaped extracted portions inside the contour defining the outer shape of the paste films.. Specifically, there is employed a screen printing plate which includes, as a negative pattern of the paste film, the outside corresponding part corresponding to an outside area of the contour of the paste film, island-shaped corresponding parts corresponding to the island-shaped extracted part, and reinforcing linking parts provided to link the plural island-shaped corresponding parts with a width less than the diameter of the island-shaped corresponding part and has an emulsion area through which the conductive paste is not allowed to pass. Accordingly, it is possible to restrain print feathering from occurring. However, since the reinforcing linking parts happen to be non-discharging areas, it is not possible to perform screen printing on the entire surface other than the island-shaped parts.
[Patent Document 1] JP-B-3582480

### SUMMARY OF THE INVENTION

In view of the problem of the above-described related art, the present invention may provide a screen printing plate capable of forming minute through-holes in a stable manner; a thick film having through-holes, which is formed by the screen printing plate; a multilayer wiring structure with a thick film having the through-holes; and an image display apparatus

According to an aspect of the present invention, there is provided a screen printing plate for performing printing by causing a squeegee to be slid to discharge printing liquid. The screen printing plate comprises: a discharging area from which printing liquid is discharged; and a non-discharging area from which no printing liquid is discharged. In the screen printing plate, the non-discharging area is of a polygonal shape having as an apex the point with which the squeegee first comes in contact when being slid, and a width of the non-discharging area in a length direction of the squeegee increases from the apex to a maximum of the width, and the non-discharging area has a diameter of 50 µm or more and less than 300 µm. Accordingly, it is possible to provide the screen printing plate capable of forming minute through-holes in a stable manner.

According to an embodiment of the present invention, it is possible to provide a screen printing plate capable of forming minute through-holes in a stable manner; a thick film having through-holes, which is formed by the screen printing plate; a multilayer wiring structure having a thick film having the through-holes; and an image display apparatus.

### BRIEF DESCRIPTION OF THE DRAWINGS

FIG. 1 is a drawing showing an example of a screen printing plate of an embodiment of the present invention;
FIGS. 2A through 2C are drawings describing the mechanism of restraining ink from oozing out under through-hole patterns;
FIGS. 3A through 3D are drawings showing specific examples of through-hole patterns;
FIG. 4 is a drawing showing the screen printing plate of Example 1;
FIGS. 5A and 5B are drawings showing the screen printing plate of Comparative Example 1 and the formed through-holes thereof, respectively;
FIGS. 6A and 6B are drawings showing a through-hole pattern of Example 2 and that of Comparative Example 2, respectively;
FIGS. 7A and 7B are drawings showing the screen printing plate of Example 3 and Comparative Example 3 and the through-hole patterns thereof, respectively;
FIG. 8 is a drawing showing the screen printing plate of Example 4;
FIG. 9 is a drawing describing the minimum diameters of through-hole patterns;
FIG. 10 is a drawing showing an example of the multilayer wiring structure of the present invention; and
FIG. 11 is a drawing showing an example of the image display apparatus of the present invention.

### DETAILED DESCRIPTION OF THE PREFERED EMBODIMENTS

Next, a description is made about preferred embodiments to carry out the present invention with reference to the accompanying drawings.

A screen printing plate of an embodiment of the present invention includes through-hole patterns which are of a polygonal shape each having as an apex the point with which a squeegee first comes in contact and whose width in the length direction of the squeegee gradually increases from the apex up to the maximum of the width of the through-hole pattern when the squeegee is slid to discharge ink so as to perform printing. Accordingly, it is possible to restrain ink from oozing out under the through-hole patterns at printing and form minute through-holes in a stable manner even in a large area.

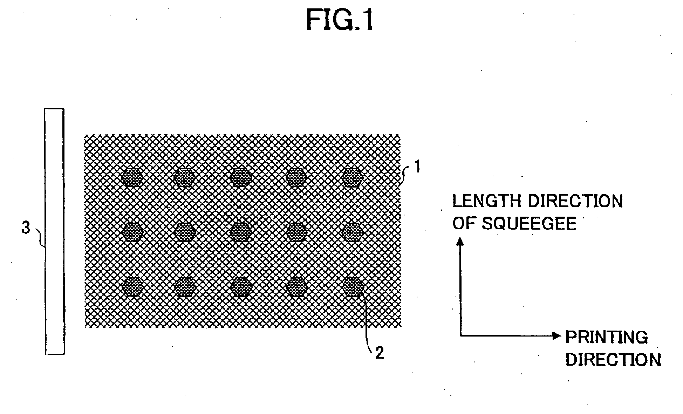

FIG. 1 shows an example of the screen printing plate of the present invention. The screen printing plate as shown in FIG. 1 has regular hexagonal through-hole patterns 2 formed on a mesh 1. The through-hole patterns 2 are non-discharging areas of ink at printing. In performing printing in the printing direction (direction in which the squeegee 3 is slid) as shown in FIG. 1, each of the through-hole patterns 2 is of a regular hexagonal shape having as the apex the point with which the squeegee first comes in contact and whose width in the length direction of the squeegee gradually increases from the apex up to the maximum of the through-hole pattern 2. Accordingly, it is possible to form a thick film having through-holes. Note that the length direction of the squeegee is generally orthogonal to the printing direction.

In the present embodiment, a description is given below of the mechanism of restraining ink from oozing out under the through-hole patterns 2 by forming the through-hole patterns 2 in such a shape and arrangement that the point with which the squeegee 3 first comes in contact at printing is the apex.

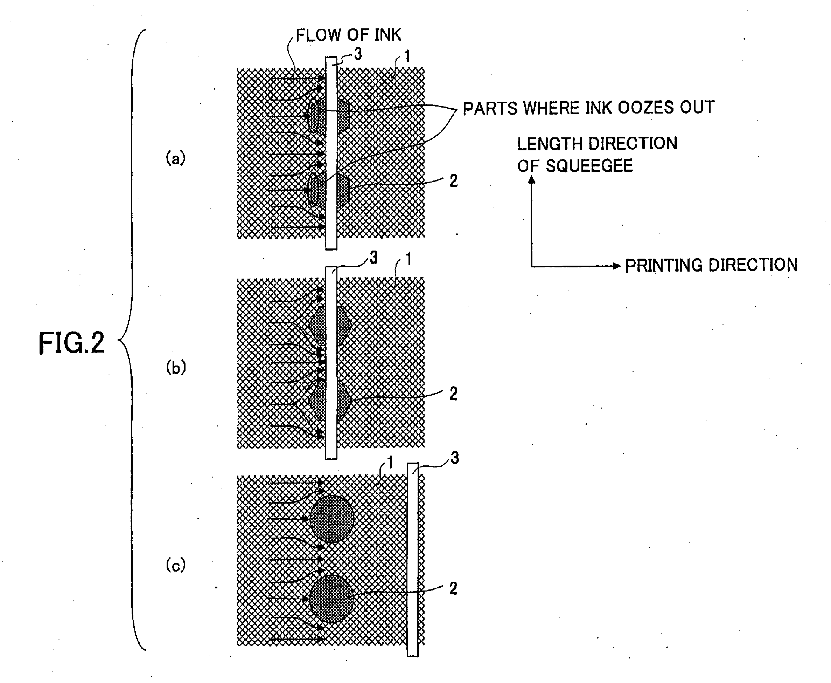

" FIG. 2A shows an example of the through-hole pattern 2 whose side first comes in contact with the squeegee 3 in the printing direction. When printing is performed in the printing direction of FIG. 2A to discharge ink into places other than the through-hole patterns 2, the ink flows as shown in FIG. 2A. The ink on the upstream side of the through-hole patterns 2 is intercepted by the through-hole patterns 2 when the squeegee 3 passes through the through-holes patterns 2. However, some of the ink is caused to ooze out under the through-hole patterns 2 by the pressure of the squeegee 3. At this time, the ink oozing out under the through-hole patterns 2 is printed on the areas where through-holes of a print member are to be formed and fills in the through-holes. In addition, since the ink remaining under the through-hole patterns 2 has an adverse affect on the subsequent printing, the repeating stability of the printing would be impaired.

On the other hand, assume that there are formed the through-hole patterns 2 whose apexes first come in contact with the squeegee 3 in the printing direction, as shown in FIG. 2B. The ink on the upstream side of the through-hole patterns 2 can flow along both sides of the through-hole patterns 2, thereby making it is possible to restrain the ink from oozing out under the through-hole patterns 2. As a result, it is possible to restrain the ink oozing out under the through-hole patterns 2 from being printed on the areas where the through-holes are to be formed and form minute through-holes in a stable manner.

Furthermore, assume that the through-hole patterns 2 are of a shape such as a circle or an ellipse having no apex as shown in FIG. 2C. Ink is less likely to ooze out under the through-hole patterns 2 compared with the case of FIG. 2A while it is more likely to ooze out under the through-hole patterns compared with that of FIG. 2B. This is because the ink in the case of FIG. 2B easily flows along both sides of the through-hole patterns 2 when the squeegee 3 passes through the through-hole patterns 2.

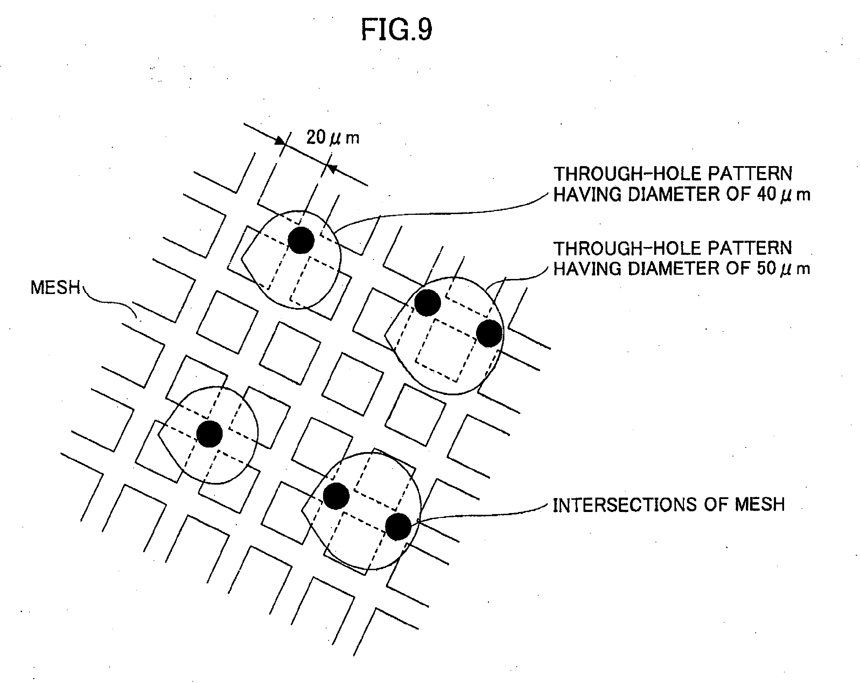

The above-described effect of the screen printing plate of the present embodiment is particularly useful if the diameter of the through-hole pattern 2 is less than 300 µm, namely, if the length of the side of a minimum square including the through-hole pattern 2 is less than 300 µm. Furthermore, the minimum diameter of the through-hole pattern 2 depends on the wire diameter of the mesh 1 for use in the screen printing plate. It is thus theoretically possible to reduce the diameter of the through-hole pattern 2 as the wire diameter of the mesh 1 is reduced. The finest mesh 1 currently available is one obtained by weaving a wire rod having a wire diameter of about 10 µm at a density of 840 pieces per inch. As shown in FIG. 9, the diameter of the opening (discharging area) of the mesh 1 is about 20 µm. In.order to have the through-hole patterns 2 supported on the mesh 1, it is generally required for each of the through-hole patterns 2 to include two or more intersections of the mesh 1. This is because, if the through-hole patterns 2 include one intersection of the mesh, the mesh 1 contacts the through-hole patterns 2 at small areas, which may result in the dropping of the through-hole patterns 2 at printing. When the through-hole patterns 2 having a diameter of 40 µm are formed on the mesh 1, for example, it is difficult for the through-hole patterns 2 to include two intersections of the mesh as shown in FIG, 9. If the through-hole patterns 2 have a diameter of 50 µm, on the other hand, it is possible for them to substantially include two or more intersections of the mesh. With the through-hole patterns 2 having a diameter of 50 µm or more, it is possible to form minute through-holes in a stable manner even in a large area. Assuming that the wire diameter of the mesh 1 is about 15 µm, furthermore, the diameter of the through-hole pattern capable of forming minute through holes in a stable manner even in a large area is 80 µm or more.

As shown in FIG. 1, each of the through-hole patterns 2 is preferably axisymmetric with respect to the axis in the printing direction in the present invention. Accordingly, the ink on the upstream side of the through-hole patterns 2 can uniformly flow along both sides of the through-hole patterns 2, making it possible to further restrain the ink from oozing out under the through-hole patterns 2.

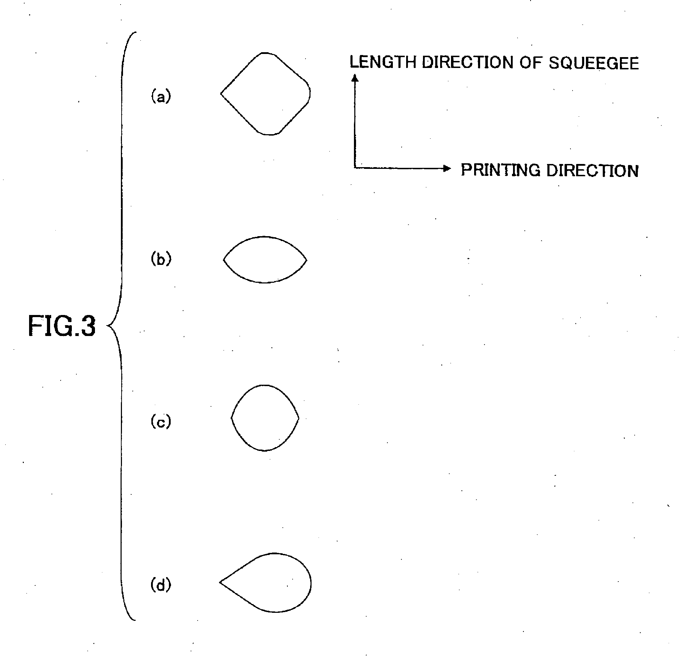

In the present embodiment, the through-hole patterns 2 are preferably of a shape so that one or more corners other than the one including the apex with which the squeegee 3 first comes in contact are formed into a curved line, and are particularly preferably of a shape so that all the corners other than the one including the apex with which the squeegee 3 first comes in contact are formed into a curved line. Since with this particular preference the through-hole patterns 2 have the corners, one corner including the apex with which the squeegee 3 first comes in contact and the other ones being formed into a curved line, the ink on the outside of the through-hole patterns 2 easily smoothly flows along the curved line, thereby making it possible to further restrain the ink from oozing out under the through-hole patterns 2. Since the corners of printed through-hole patterns are formed into a curved line, the surface tension at the edge of the through-holes is equalized, thereby making it possible to restrain the occurrence of feathering caused by the fluidity of ink. Note that although examples of the curved line in this case include a circle, an ellipse, a parabola, or the like, the curved lines are not particularly limited so long as they are projected to the outside. FIGS. 3A through 3D show specific examples of such through-hole patterns 2. FIG. 3A shows a square in which three corners are formed into a curved line, FIG. 3B and 3C each show a rhombus in which two corners are formed into a curved line, and FIG. 3D shows a rhombus in which three corners are formed into a curved line.

Note, however, that the surface of the ink discharged from the screen printing plate becomes even due to gravity, and at the same time, a small amount of feathering is caused to occur because of the principle of the screen printing method. Therefore, the through-hole patterns of the screen printing plate of the present invention do not strictly match the shapes of the through-holes to be formed.

In the present embodiment, the through-hole patterns 2 can be formed by publicly known methods. For example, it is possible to apply photolithography to the mesh 1 having a photosensitive emulsion coated thereon so as to form the through-hole patterns 2.

A thick film having through-holes of the present embodiment is formed by performing printing with the screen printing plate of the invention. Specifically, after ink is applied to the screen printing plate arranged on a print member, the squeegee 3 is slid in the printing direction on the screen printing plate having the ink applied thereon as shown in FIG. 1. Accordingly, the ink is discharged from discharging areas other than the through-hole patterns 2 (non-discharging areas) of the mesh 1 into the print member. Subsequently, the print member having the ink discharged thereon is dried (hardened) to thereby obtain the thick film having through-holes.

In the present embodiment, ink used for forming a thick film having through-holes is not particularly restricted, and publicly known materials containing resin components, fillers, and solvents are available. In order to form through-holes, each having a diameter of 300 µm or less, it is particularly preferable to use ink which does not easily flow at printing and drying. Specifically, examples of the ink include one which has a viscosity of 100 Pa·s or more under the temperature condition to perform printing and a solid volume ratio of 25% or more of the ink.

In the present embodiment, an insulation material is used to form a thick film having through-holes to thereby obtain an insulation film having the through-holes.

Note that a film thickness of a thick film having through-holes is determined by the formula, (thickness of mesh × opening ratio + thickness of emulsion) × solid volume ratio of ink. Accordingly, it is possible to form a thick film having a predetermined film thickness by adjusting the respective parameters as needed.

An interlayer wiring structure of the present embodiment can be formed by laminating the thick film (interlayer insulation film) having through-holes of the invention with plural electrodes with a predetermined arrangement and electrically connecting upper and lower electrodes of the interlayer insulation film to each other via the through-holes. Accordingly, it is possible to greatly reduce the manufacturing steps and obtain a miniaturized multilayer wiring structure. In order to have the upper and the lower electrodes of the interlayer insulation film electrically connected to each other, it is preferable to fill in the through-holes with a conductive layer. At this time, it is further preferable to form upper electrodes at the upper portions of the interlayer insulation film and fill in the through-holes with the conductive layer by the screen printing method. It is thus possible to use the same apparatus and simplify the manufacturing process.

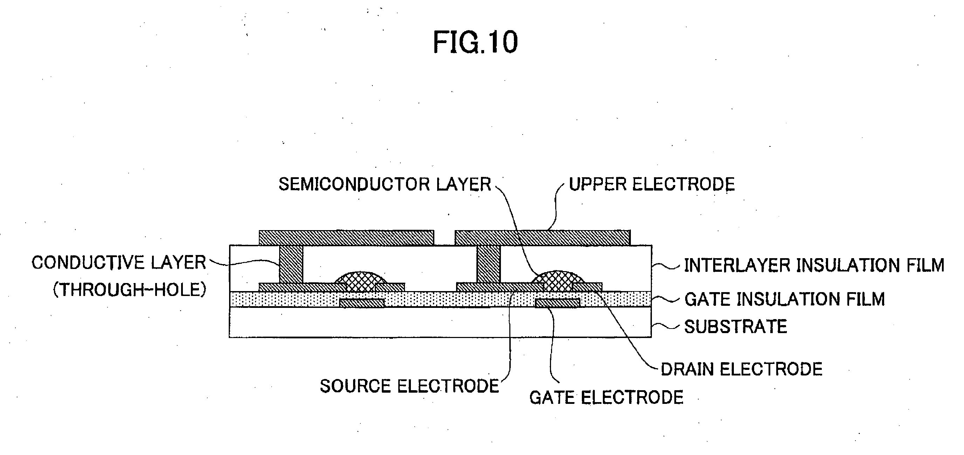

FIG. 10 shows an example of the multilayer wiring structure of the present embodiment. On transistors, each having a gate electrode, a gate insulation film, source/drain electrodes, and semiconductor layers formed on a substrate, there is formed an interlayer insulation film having through-holes. Moreover, a conductive layer fills in the through-holes, and the upper electrodes are formed on the interlayer insulation film. The upper electrodes and the conductive layer can be formed by the use of commercially-available conductive pastes containing conductive materials. Examples of the conductive materials include silver, copper, aluminum, carbon, or the like.

An image display apparatus of the present embodiment can be formed by laminating image display elements on an active matrix substrate in which transistor elements are provided in a lattice shape, where transistors and pixel electrodes are electrically connected to each other via the through-holes through the thick film (interlayer insulation film). Accordingly, it is possible to obtain a slim and lightweight image display apparatus with an easy manufacturing process. Note that a liquid crystal display element, an electrophoretic display element, and an organic EL (electroluminescence) element can be used as the image display element. Accordingly, it is possible to obtain a flat-panel type or flexible image display apparatus, which can reduce the burden on a viewer's eyes.

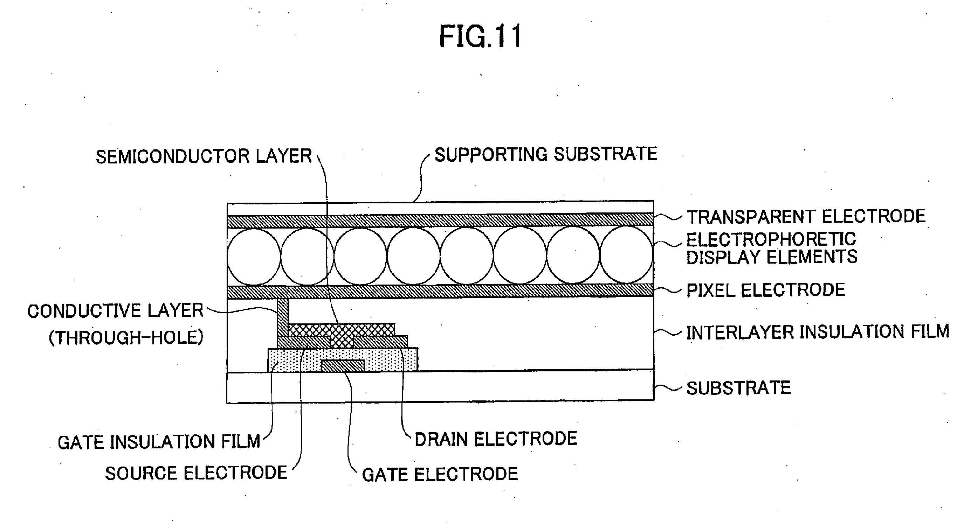

FIG. 11 shows an example of the image display apparatus of the present embodiment. On the transistors, each having the gate electrode, the gate insulation film, the source/drain electrodes, and the semiconductor layer formed on the substrate, there is formed the interlayer insulation film having through-holes. Moreover, the conductive layer fills in the through-holes, and the pixel electrodes are formed on the interlayer insulation film. On the active matrix substrate having such a configuration, there are bonded electrophoretic display elements formed on a supporting substrate and covered by a transparent electrode.

### Examples

### (Example 1)

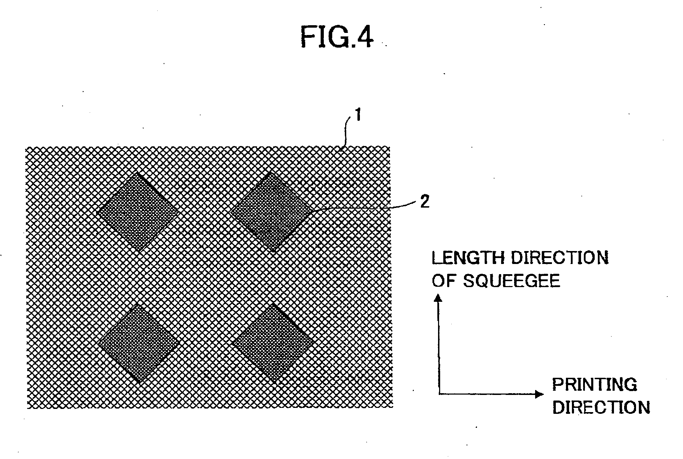

There was employed, as the screen printing plate, one in which the square through-hole patterns 2, 200 µm on a side, were arranged in a matrix form at intervals of 400 µm (see FIG. 4) on the mesh 1 (200 mm × 200 mm) having a wire diameter of 23 µm and an opening ratio of about 50%. Note that the through-hole patterns 2 are axisymmetric with respect to the axis in the printing direction as shown in FIG. 4 and have the apex with which the squeegee first comes in contact. Furthermore, the through-hole patterns 2 were by formed by exposing, developing, and drying a mesh coated with a photosensitive emulsion via a photomask having the through-hole patterns formed thereon.

After being printed with the screen printing plate and a thick film paste in the printing direction as shown in FIG. 4, a polycarbonate film substrate (220 mm × 220 mm) having a thickness of 120 µm was dried for 60 minutes at 100°C to obtain a thick film. Note that there was employed, as the thick film paste, one prepared by dissolving a polyvinyl alcohol resin in a solvent and then adding a filler and a viscosity modifier thereto to have a viscosity of about 200 Pa·s.

As a result of the evaluation of the obtained thick film with a length measuring microscope, it was found that through-holes substantially in the shape of a square were formed on the entire surface of the thick film. Note that a side of the formed through-holes was 160 µm on average.

### (Comparative Example 1)

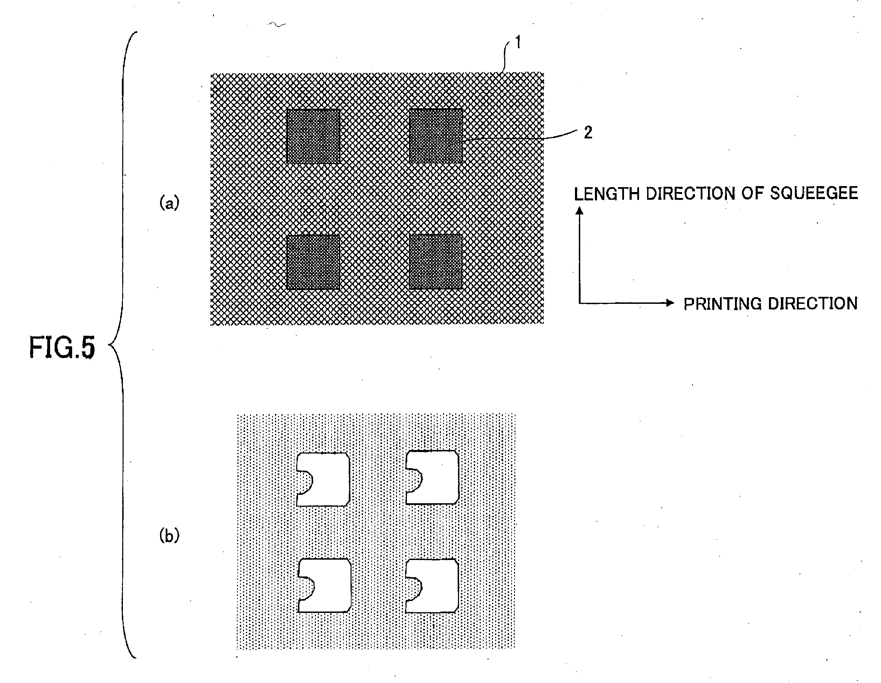

Except that the screen printing plate as shown in FIG. 5A was used instead of that as shown in FIG. 4, a thick film was formed in the same manner as Example 1. Note that the through-hole patterns 2 are axisymmetric with respect to the axis in the printing direction as shown in FIG. 5A and have the side with which the squeegee first comes in contact.

As a result of the evaluation of the obtained thick film with a length measuring microscope, it was found that amorphous through-holes as shown in FIG. 5B were formed on the entire surface of the thick film. The formed through-holes were caused to slightly shrink in the printing direction, and they were 160 µm long × 145 µm wide on average..

### (Example 2)

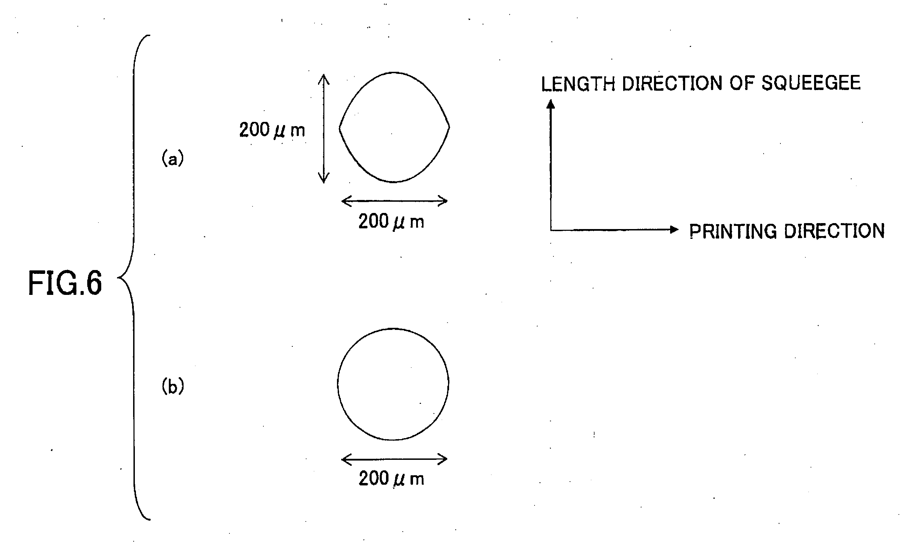

Except that the through-hole patterns 2 of the screen printing plate as shown in FIG. 4 were changed to circular through-hole patterns having a diameter of 200 µm as shown in FIG. 6A, a thick film was formed in the same manner as Example 1. Note that the through-hole patterns are axisymmetric with respect to the axis in the printing direction as shown in FIG. 6A and have the apex with which the squeegee first comes in contact..

On the entire surface of the obtained thick film, there were formed through-holes having a shape substantially the same as that of the through-hole patterns" The formed through-holes were 160 µm long × 160 µm wide on average.

### (Comparative Example 2)

Except that the through-hole patterns 2 of the screen printing plate as shown in FIG. 4 were changed to circular through-hole patterns having a diameter of 200 µm as shown in FIG. 6B, a thick film was formed in the same manner as Example 1.

Through-holes were formed on the entire surface of the obtained thick film.. The formed through-holes were caused to slightly shrink in the printing direction, and they were 160 µm long x 150 µm wide on average.

As compared with Example 2, it is found that although the areas of the through-hole patterns on the screen printing plate of Example 2 are smaller than those of Comparative Example 2, the through-holes formed in Example 2 are larger in size than those formed in Comparative Example 2.

### (Example 3 and Comparative Example 3)

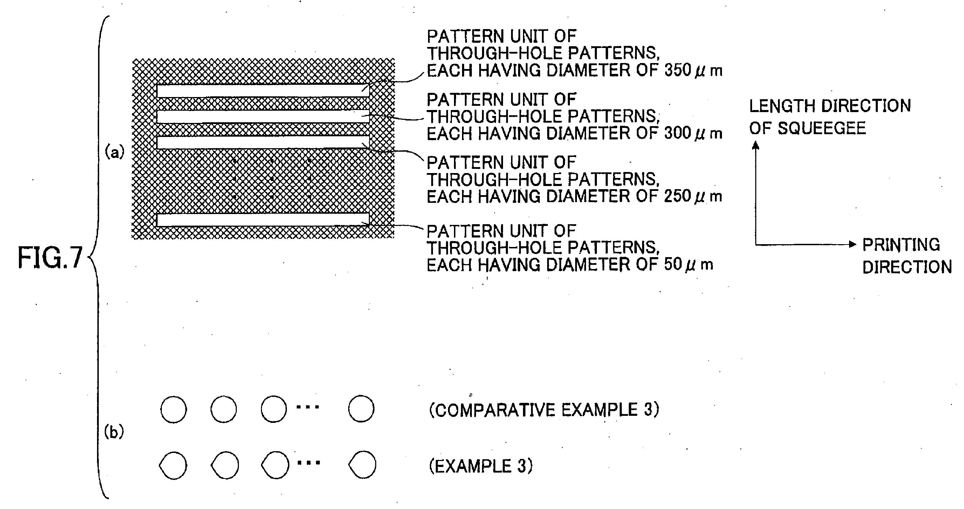

As shown in FIG. 7A, there was employed, as the screen printing plate, one in which pattern units having through-hole patterns, each having a diameter of 350, 300, 250, 200, 150, 100, and 50 µm were formed on a mesh having a wire diameter of 18 µm and an opening ratio of about 40%. Note that, as shown in FIG. 7B, 1000 pieces of two types of circular (Comparative Example 3) and droplet (Example 3) through-hole patterns were arranged in each of the pattern units at intervals of 500 µm. At this time, the through-hole patterns 2 were formed by exposing, developing, and drying a mesh coated with a photosensitive emulsion via a photomask having the through-hole patterns formed thereon. Furthermore, the droplet through-hole patterns (Example 3) are axisymmetric with respect to the axis in the printing direction as shown in the figure and have the apex with which the squeegee first comes in contact. In addition, the width of the droplet through-hole patterns in the printing direction is identical in size with that in the length direction of the squeegee.

After being printed with the screen printing plate and an insulating paste in the printing direction as shown in FIG. 7A, a washed glass substrate was dried for 30 minutes at 110°C to obtain an insulation film. Note that there was employed, as the insulating paste, one prepared by dissolving a polyvinyl butyral resin in a solvent and then adding an inorganic filler having an average particle diameter of 0..1 µm thereto to have a viscosity of about 400 Pa·s.

The obtained insulation film was examined under a microscope to evaluate the number of through-holes formed without being filled in each of the pattern units. Table 1 shows the evaluation results.

**TABLE 1**

| DIAMETERS OF THROUGH-HOLE PATTERNS [µm] | EXAMPLE 3 | COMPARATIVE EXAMPLE 3 |
|---|---|---|
| 350 | 1000 | 1000 |
| 300 | 10.00 | 1000 |
| 250 | 1000 | 998 |
| 200 | 1000 | 915 |
| 150 | 1000 | 780 |
| 100 | 995 | 635 |
| 50 | 550 | 360 |

As apparent from Table 1, in order to form the through-holes in a stable manner, it is required for the through-hole patterns to have a diameter of 300 µm or more in the case of Comparative Example 3 and that of 150 µm or more in the case of Example 3.

### (Example 4)

Nano-silver ink was formed on a polycarbonate substrate by an ink jet method and then dried to form gate electrodes. Next, a gate insulation film was formed by applying thermal polymerization polyimide thereto by a spin coating method and thermal-treating it at 190°C. The formed gate insulation film had a relative permittivity of 3.6 and a film thickness of 0-4 µm. Ultraviolet rays were applied to the areas, on which source/drain electrodes will be formed via a photomask, to modify the surface of the areas. In addition, nano-silver ink was formed on the areas by the ink jet method and then dried to form the source/drain electrodes. Next, an organic semiconductor material expressed by the structural formula 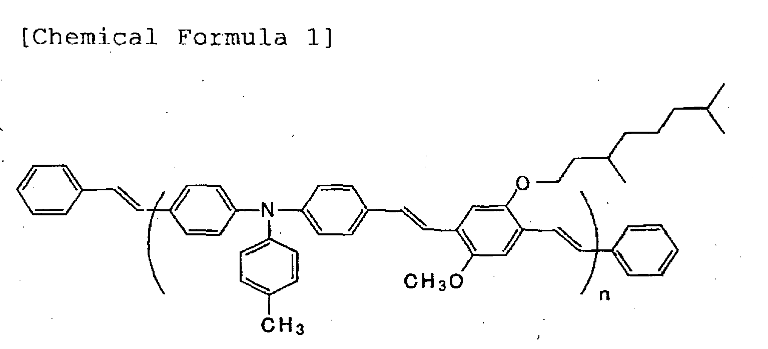 was dissolved in xylene to form ink. The resulting ink was formed into a film by the ink jet method to form an organic semiconductor layer, thereby obtaining organic transistors. The organic transistors thus obtained had a channel length of 5 µm and a channel width of 2 mm.

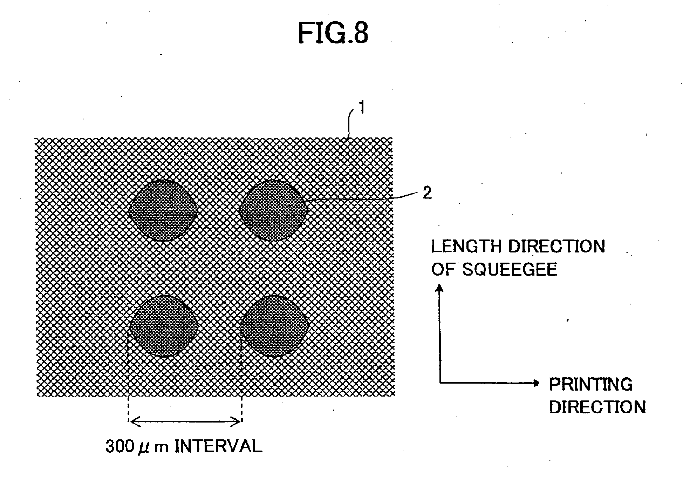

There was employed, as the screen printing plate, one in which the through-hole patterns 2 similar to those of FIG. 6A were arranged in a matrix form at intervals of 300 µm (see FIG.. 8) on the mesh 1 (200 mm × 200 mm) having a wire diameter of 23 µm and an opening ratio of about 50%. Note that the through-hole patterns 2 are axisymmetric with respect to the axis in the printing direction as shown in FIG. 8 and have the apex with which the squeegee first comes in contact.

After being printed with the screen printing plate as shown in FIG. 8 and an insulating paste in the printing direction as shown in FIG. 8, the organic transistors were dried to obtain an interlayer insulation film having through-holes. Note that there was employed, as the insulating paste, one prepared by dissolving a polyvinyl acetal resin in a solvent and then adding an inorganic filler having an average particle diameter of 0.1 µm thereto to have a viscosity of about 400 Pa·s

In addition, a silver paste made of Ag particles, an acryl resin, and a solvent was formed on the interlayer insulation film by the screen printing method and then dried to fill in the through-holes of the interlayer insulation film with conductive layers and form pixel electrodes electrically connected to low-level organic transistors, thereby obtaining an active matrix substrate in which transistor elements are arranged in a lattice shape.

Next, 20 parts by weight of titanium oxide, 1 part by weight of acid polymer, 2 parts by weight of silicon polymer graft carbon black MX3-GRX-001 (manufactured by Nippon Shokubai Co., Ltd.), 77 parts by weight of silicon oil KF96L-lcs (manufacture by Shin-Etsu Chemical Co., Ltd.) were mixed together and then dispersed for one hour with ultrasonic waves to obtain a dispersion liquid with black and white particles. Microcapsules were made from the dispersion liquid by a gelatin/acacia gum complex coacervation method. At this time, the average particle diameter of the microcapsules was about 60 µm. The dispersion liquid prepared by dispersing the microcapsules thus obtained in a urethane resin solution was spread on a film substrate with a transparent electrode film by a wire blade method, thereby forming a uniform microcapsule sheet. Consequently an electrophoretic display element was obtained.

The electrophoretic display element thus obtained was bonded to the active matrix substrate to obtain the image display as shown in FIG. 11

The present invention is not limited to the specifically disclosed embodiments, and variations and modifications may be made without departing from the scope of the present invention.

## Claims

1. A screen printing plate configured to be used with a squeegee that is slid to discharge printing liquid so as to perform printing, the screen printing plate comprising:
a discharging area from which printing liquid is discharged; and
a non-discharging area from which no printing liquid is discharged; wherein
the non-discharging area is of a polygonal shape having as an apex the point with which the squeegee first comes in contact when being slid, and
the width of the non-discharging area in the length direction of the squeegee increases from the apex to a maximum of the width,
**characterized in that** the non-discharging area has a diameter of 50 µm or more and less than 300 µm.

2. The screen printing plate according to claim 1, **characterized in that**
the non-discharging area is axisymmetric with respect to the axis in the direction in which the squeegee is slid.

3. The screen printing plate according to claim 1, **characterized in that**
the non-discharging area has the shape in which one or more corners other than the apex are formed into a curved line.

4. A thick film having a through-hole, which is formed by printing with the screen printing plate according to claim 1.

5. The thick film according to claim 4, which is made of an insulation material.

6. A multilayer wiring structure which includes at least the thick film having a through-hole according to claim 4.

7. An image display apparatus which includes at least the thick film having a through-hole according to claim 4.

## Patentansprüche

1. Siebdruckplatte, die dazu ausgelegt ist, mit einem Quetscher verwendet zu werden, der verschoben wird, um Druckflüssigkeit auszutragen, um einen Druckvorgang durchzuführen, wobei die Siebdruckplatte aufweist:
einen austragenden Bereich, aus dem Druckflüssigkeit ausgetragen wird; und
einen nicht austragenden Bereich, aus dem keine Druckflüssigkeit ausgetragen wird; wobei
der nicht austragende Bereich von einer polygonalen Form ist, der den Punkt als einen Scheitelpunkt hat, mit dem der Quetscher beim Verschieben zuerst in Kontakt kommt, und
die Breite des nicht austragenden Bereichs in der Längenrichtung des Quetschers ausgehend vom Scheitelpunkt bis zu einem Höchstwert der Breite zunimmt,
**dadurch gekennzeichnet, dass** der nicht austragende Bereich einen Durchmesser von 50 µm oder darüber und von weniger als 300 µm hat.

2. Siebdruckplatte nach Anspruch 1, **dadurch gekennzeichnet, dass** der nicht austragende Bereich im Hinblick auf die Achse in der Richtung achssymmetrisch ist, in der der Quetscher verschoben wird.

3. Siebdruckplatte nach Anspruch 1, **dadurch gekennzeichnet, dass** der nicht austragende Bereich die Form hat, bei der eine oder mehrere Ecke/n, anders als der Scheitelpunkt, in einer gekrümmten Linie ausgebildet sind.

4. Dickfilm mit einer Durchgangsöffnung, der durch Bedrucken mit der Siebdruckplatte nach Anspruch 1 gebildet ist.

5. Dickfilm nach Anspruch 4, der aus einem Isoliermaterial hergestellt ist.

6. Mehrlagige Verdrahtungsstruktur, die zumindest den Deckfilm mit einer Durchgangsöffnung nach Anspruch 4 umfasst.

7. Bildanzeigevorrichtung, die zumindest den Dickfilm mit einer Durchgangsöffnung nach Anspruch 4 umfasst.

## Revendications

1. Plaque de sérigraphie configurée pour être utilisée avec une raclette qui est amenée à glisser pour décharger un liquide d'impression de manière à effectuer une impression, la plaque de sérigraphie comprenant :
une zone de décharge depuis laquelle le liquide d'impression est déchargé ; et
une zone sans décharge depuis laquelle aucun liquide d'impression n'est décharge ; où
la zone sans décharge est de forme polygonale ayant en tant que sommet le point avec lequel la raclette entre en contact en premier lorsqu'elle est amenée à glisser, et
la largeur de la zone sans décharge dans la direction de la longueur de la raclette augmente du sommet à un maximum de la largeur,
**caractérisée en ce que** la zone sans décharge a un diamètre de 50 µm ou plus et moins de 300 µm.

2. Plaque de sérigraphie selon la revendication 1, **caractérisée en ce que**
la zone sans décharge est asymétrique par rapport à l'axe dans la direction dans laquelle la raclette est amenée à glisser.

3. Plaque de sérigraphie selon la revendication 1, **caractérisée en ce que**
la zone sans décharge a la forme dans laquelle un ou plusieurs coins autres que le sommet sont formés en une ligne courbée.

4. Film épais ayant un trou de passage, qui est formé par impression avec la plaque d'impression selon la revendication 1.

5. Film épais selon la revendication 4, qui constitué d'un matériau isolant.

6. Structure de câblage multicouche qui comprend au moins le film épais ayant un trou de passage selon la revendication 4. :

7. Appareil d'affichage d'image qui comprend au moins le film épais ayant un trou de passage selon la revendication 4.
